# EUROPEAN PATENT SPECIFICATION

(11) **EP 3 747 059 B1**
(45) Date of publication and mention of the grant of the patent: **16.11.2022**
(21) Application number: 19704416.7
(22) Date of filing: 31.01.2019
(51) Int. Cl.: H01L 35/32, H01L 35/34

(54) **THERMOELECTRIC MODULE**
THERMOELEKTRISCHES MODUL
MODULE THERMOÉLECTRIQUE

(30) Priority: 31.01.2018 GB 201801612
(43) Date of publication of application: 09.12.2020
(73) Proprietor: European Thermodynamics Limited, Leicester, Leicestershire LE8 0RX (GB); Queen Mary University of London, London, Greater London E1 4NS (GB)
(72) Inventor: BILOTTI, Emiliano, London SW7 2AZ (GB); ILIFFE, Samuel, Cambridge CB2 8BP (GB); TARONI JUNIOR, Prospero, London WC1E 7JE (GB); WAN, Kening, Jiashan Jiaxing Zhejiang Province 314100 (CN); TULEY, Richard, Kibworth Leicester, Leicestershire LE8 0RX (GB)
(74) Representative: Barker Brettell LLP
(86) International application number: PCT/GB2019/050272
(87) International publication number: WO 2019/150120

(56) References cited:
- WO-A1-2017/038525
- WO-A1-2017/038773
- US-A1- 2011 220 162
- US-A1- 2017 244 019

## Description

The present invention relates to thermoelectric modules and thermoelectric devices comprising thermoelectric modules, in particular, but not exclusively, thermoelectric devices for energy generation. In particular, the invention relates to a thermoelectric generator and a method of making such a thermoelectric generator.

Many electrical systems, such as sensors, may be in positions where it is not convenient or economically viable to power them by means of hard wiring them to a central power source such as the electrical grid. For example, if the electrical system is in a remote or inaccessible location or is required to be mobile, mains power is not available. Typically, such electrical systems may be powered by batteries. However, batteries are limited by the total stored charge, and therefore access to the electrical system is needed to replace the batteries. Such access can be challenging, unsafe, inconvenient and/or expensive, therefore making the systems difficult to maintain.

Moreover, the need to frequently replace batteries can be expensive and is not environmentally friendly. The need to have sufficient replacement batteries available can also be detrimental if space and/or weight is at a premium.

One solution to these problems is to have an energy generation device associated with the electrical system, so that it can be electrically self-sufficient (so-called "fit-and-forget") and/or to increase the lifetime of a battery. For example, the energy generation device may re-charge one or more batteries.

A thermoelectric generator is an example of such an energy generating device, and can be used wherever there is a temperature difference. For example, a thermoelectric generator can operate using the temperature difference between a hot pipe or surface and the ambient air temperature.

Generally, the temperature differences available are often small, and so a standard thermoelectric generator module may produce sufficient power, but at a very low voltage. The low voltages can be difficult to interface efficiently with the required electrical system. There is therefore a need to create thermoelectric generators capable of producing sufficiently high voltages even at low temperature differences.

To achieve a high voltage at low temperature differences, a large number of thermoelectric elements (e.g. semiconductors) need to be connected electrically in series. To minimise the required amount of thermoelectric material it can therefore be advantageous to use many thermoelectric elements of low cross sectional area perpendicular to the temperature gradient. Using standard processes to create thermoelectric modules it can be challenging to create very low cross sectional area of the thermoelectric elements perpendicular to the temperature gradient, due to the requirements of mechanical stability, reduced yield in assembly and increased material wastage in cutting operations. Therefore, in a standard thermoelectric generator module a large number of thermoelectric elements may result in a large and costly device.

An alternative method to produce a large number of thermoelectric elements is to have the thermoelectric elements disposed on a substrate, with a temperature gradient predominantly parallel to the substrate. This allows the use of a much smaller cross section of a thermoelectric element perpendicular to the temperature gradient; as for example the substrate support may provide mechanical support, ease of handling and easier thermoelectric element formation. In order to then achieve the required number of thermoelectric elements, the substrates can be stacked or layered in a compact or low cost manner.

US9660167 B2 discloses a method of forming layers of thermoelectrically active materials being disposed on a flexible and electrically insulating layer so as to form a matrix of n rows of the thermocouple limbs in columns having a same width; wherein contact regions of adjacent ones of the thermocouple limbs are each disposed on a straight fold line above one another in the column direction, and wherein the matrix is wound parallel to the rows on top of one another to form a flat strip and folded along the fold lines in the manner of a concertina with elevations and depressions equidistant to one another.

WO2017038553 A1 discloses a thermoelectric conversion module that has a bellows-shaped insulating substrate that comprises alternatingly repeating first and second sections which are oriented in different directions. A P-type thermoelectric conversion element and/or an N-type thermoelectric conversion element is provided on one surface of the first sections. At least one element having a different polarity than the element on the one surface and selected from among the p-type thermoelectric conversion element and the n-type thermoelectric conversion element is provided on the other surface of the second sections that is on the opposite side thereof from the one surface.

US7851691 B2 discloses rolling or folding thermoelectric elements on a substrate.

EP 1629539 B1 discloses partial folding of a thin film thermoelectric device.

US 20110214707 A1 discloses using a cut line on a fold line in a thermoelectric device.

After the thermoelectric elements have been disposed on the substrate, they need to be assembled into a device. The substrate and thermoelectric are typically much thinner than the space available for the device perpendicular to the heat flow, so a single substrate or part of substrate would result in a device with a high aspect ratio perpendicular to the heat flow, only using a small amount of the space available, with the resulting low power and voltage. Therefore a device is usually assembled by stacking a number of substrates or parts of substrates thermally in parallel and electrically in series, or folding up or spirally winding the substrate(s) or parts of substrates.

Stacking substrates requires electrically joining each substrate together with a low resistance joint. For the large number of joints for a practical device this is not a low cost manufacturing method.

It is important to avoid electrical shorting between substrates or parts of substrates when assembled into a device. Therefore for example, if the device is folded in a concertina fashion, either an additional insulating layer needs to be used between the layers, or significant areas of the substrate must be unused, or the folds of the substrate must be permanently and reliably spaced apart. All of these approaches add cost and increase the size of the device, while detrimentally affecting performance due to the additional heat flow paths.

Alternatively the substrate can be spirally wound. However this leads to bending of the thermoelectric elements, which can detrimentally affect their performance (for example cracking of brittle thermoelectric materials). US9660167 B2 Fig. 2b discloses a method of spirally winding the material with the bending occurring outside the thermoelectric areas, but this requires an increasing bending length as the device size increases, so does not scale well with device size. US2017/0244019 A1 discloses a flexible and foldable paper-substrate thermoelectric generator (TEG). US2011/0220162 A1 on the other hand discloses thermoelectric (TE) devices/structures including thermoelectric elements with exposed major surfaces.

A first aspect provides a thermoelectric module comprising:
a continuous substrate comprising:
   a first region having disposed thereon alternating n-type and p-type thermoelectric elements connected in a first electrical series;
   a second region having disposed thereon alternating n-type and p-type thermoelectric elements connected in a second electrical series; and
   a link portion extending between the first region and the second region, the link portion having disposed thereon an electrical connection connecting the first electrical series and the second electrical series;
wherein the continuous substrate comprises a first bend or fold between the first region and a first end of the link portion and a second bend or fold between a second end of the link portion and the second region; and
wherein the link portion has a width, which is less than 25%, less than 20% or less than 15% of a length of the first portion and/or a length of the second portion. The direction of the first bend or fold may be opposite to the direction of the second bend or fold.

The continuous substrate may be flexible at least in part. The continuous substrate may be foldable or bendable at least in part.

The continuous substrate may be adapted to be foldable or bendable at specific locations. For instance, the continuous substrate may comprise a line of weakness to facilitate folding or bending at the location of the first bend or fold and/or a line of weakness to facilitate folding or bending at the location of the second bend or fold. The line(s) of weakness may comprise a pattern of scoring, partial-depth cuts and/or through-thickness cuts.

The electrical connection connecting the first electrical series and the second electrical series may comprise at least one thermoelectric element.

The first region may lie in a first plane and the second region may lie in a second plane, wherein the second plane is displaced relative to the first plane. The second plane may be displaced, e.g. translated, linearly and/or angularly relative to the first plane. The first plane may have a first orientation and the second plane may have a second orientation. The second orientation may be the same as the first orientation (i.e. the first plane and the second plane may be parallel). The second orientation may be different from the first orientation.

The first region may comprise an elongate strip extending in a first direction. The second region may comprise an elongate strip extending in a second direction. The link portion may extend between the first portion and the second portion in a direction at an angle to (i.e. not parallel to) the first direction and/or the second direction.

The thermoelectric module may be configured to fit in any envelope shape, e.g. a cuboid, a trapezoid, a segment, or an arcuate or part-helical shape.

The thermoelectric module may comprise any number of n-type and p-type thermoelectric elements.

The continuous substrate may comprise more than two regions having disposed thereon alternating n-type and p-type thermoelectric elements connected in an electrical series. The continuous substrate may comprise a link portion between each sequential pair of regions, to provide an electrical and a mechanical connection between the sequential pair of regions. Each link portion comprises a first bend or fold and a second bend or fold.

The continuous substrate may comprise up to or at least 10, up to or at least 20, up to or at least 50, up to or at least 100 or up to or at least 1000 regions having disposed thereon alternating n-type and p-type thermoelectric elements connected in an electrical series.

Spacing between the regions having disposed thereon alternating n-type and p-type thermoelectric elements connected in an electrical series may be regular and/or uniform. Spacing between the regions having disposed thereon alternating n-type and p-type thermoelectric elements connected in an electrical series may be irregular and/or non-uniform.

A second aspect provides a thermoelectric device comprising one or more thermoelectric modules according to the first aspect.

The thermoelectric device may be a thermoelectric generator.

The thermoelectric device, e.g. thermoelectric generator may be used to generate electricity.

A third aspect provides a method of manufacture of a thermoelectric module or a thermoelectric device comprising:
providing a continuous substrate comprising:
   a first region having disposed thereon alternating n-type and p-type thermoelectric elements connected in a first electrical series;
   a second region having disposed thereon alternating n-type and p-type thermoelectric elements connected in a second electrical series; and
   a link portion extending between the first region and the second region, the link portion having disposed thereon an electrical connection connecting the first electrical series and the second electrical series;
bending or folding the continuous substrate to create a first bend or fold between the first region and a first end of the link portion and a second bend or fold between a second end of the link portion and the second region;
wherein the link portion has a width, which is less than 25%, less than 20% or less than 15% of a length of the first portion and/or a length of the second portion.

The direction of the first bend or fold may be opposite to the direction of the second bend or fold.

The method may comprise:
cutting a substrate along a first cut line extending partially across the substrate from a first edge in a direction towards a second edge opposite the first edge of the substrate to partially separate the first region from the second region; and
cutting the substrate along a second cut line, the second cut line meeting the first cut line and extending partially across the substrate at an angle relative to the first cut line without reaching an edge of the substrate.

The method may include a preliminary step of depositing one or more of the thermoelectric elements and/or electrical interconnects on to the substrate.

The method may be used to manufacture a thermoelectric module according to the first aspect or a thermoelectric device according to the second aspect.

This disclosure may provide a method to transform thermoelectric elements disposed on a substrate into a thermoelectric device with the heat flow predominantly parallel to the substrate, while increasing substrate area usage, in a process compatible with high volume manufacture, without requiring an additional insulating layer.

Except where mutually exclusive, any of the features of the first aspect may be employed *mutatis mutandis* in the second and other aspects.

Example embodiments will now be described with reference to the accompanying drawings, in which:
Figure 1 is a plan view of a substrate in one embodiment;
Figure 2 is a view of the substrate in figure 1 after folding;
Figure 3 is a plan view of a substrate and thermoelectric elements in one embodiment;
Figure 4 is a view of the substrate of Figure 3 after folding;
Figure 5 is a plan view of the strips on the substrate in accordance with an embodiment;
Figure 6 is a plan view of an embodiment of the fold lines on the substrate before folding;
Figures 7A, 7B, 7C and 7D illustrate an example of the fabrication of a device of one embodiment; and
Figure 8 is an example of a different overall shape possible with an embodiment..

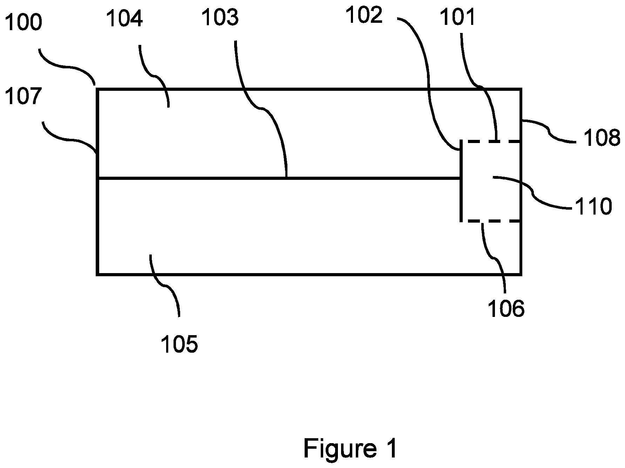

Figure 1 shows a substrate 100 which is cut along cut along a first cut line 103. The first cut line 103 extends from a first edge 107 of the substrate 100 and terminates before reaching a second edge 108 of the substrate 100, the second edge 108 being opposite the first edge 107. In the example embodiment of Figure 1, the first cut line 103 extends for approximately 90% of the distance from the first edge 107 to the second edge 108. At its end point distal from the first edge 107, the first cut line 103 meets a second cut line 102, which is transverse to the first cut line 103. In the example embodiment of Figure 1, the first cut line 103 meets the second cut line 102 midway along the length of the second cut line 102. The second cut line 102 is relatively short and neither end of the second cut line 102 meets an edge of the substrate 100. A first fold line 101 extends from a first end of the second cut line 102 to the second edge 108 of the substrate 100. A second fold line 106 extends from a second end of the second cut line 102 to the second edge 108 of the substrate 100. The first fold line 101 and the second fold line 106 are parallel with each other and extend in a direction transverse to the second cut line 102 (and parallel to the first cut line 103). The cut lines 102, 103 and fold line 101, 102 produce a continuous substrate comprising a first strip 104, a second strip 105 and a link portion 110 connecting the first strip 104 to the second strip 105. The link portion 110 is defined by the second cut line 102, the first fold line 101, a portion of the second edge 108 and the second fold line 106.

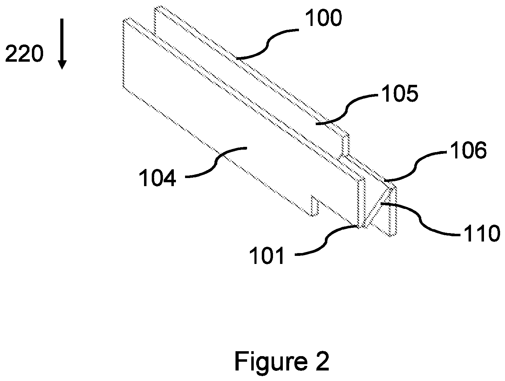

Figure 2 shows the substrate 100 after folding along the first fold line 101 and the second fold line 106. The fold at the first fold line 101 is in an opposite direction from the fold at the second fold line 106.

The substrate 100 is made of an electrically insulating material. The substrate 100 is suitable for use in a thermoelectric module (not shown). One or more thermoelectric materials and/or one or more electrical interconnects may be disposed on the first strip 104, the second strip 105 and the link portion 110. The thermoelectric material(s) and/or the electrical interconnect(s) may be deposited by any suitable process.

A thermoelectric module comprising the substrate 100 may be arranged such that a heat flow direction indicated generally by arrow 220 is predominantly parallel to the first strip 104 and the second strip 105. The first strip 104 and the second strip 105 are thermally in parallel, while being connected by the link portion 110. The first strip 104, the link portion 110 and the second strip 105 are connected in electrical series. The link portion 110 may be considered to provide a bridge between the first strip 104 and the second strip 105.

When formed in the substrate (see Figure 1), a lower edge of the first strip 104 was adjacent to an upper edge of the first strip 105. After cutting and folding (see Figure 2), the lower edge of the first strip 104 is now closer to the lower edge of the second strip 105 than the upper edge of the second strip 105. Thus, anything deposited, e.g. thermoelectric materials and/or electrical interconnects, on the one side of the substrate 100 on the first strip 104 is electrically isolated from any deposition on the same side of the substrate 100 on the second strip 105 after folding by the electrically insulating substrate itself. The area of the link portion 110 is small compared to the area of the strips 104 and 105 so this approach maximises usable substrate area. For example the area of the link portion(s) may be <25%, <20% or <15% of the substrate area.

A thermoelectric module may comprise a continuous sequence of any number of strips with link portions extending therebetween formed from a substrate.

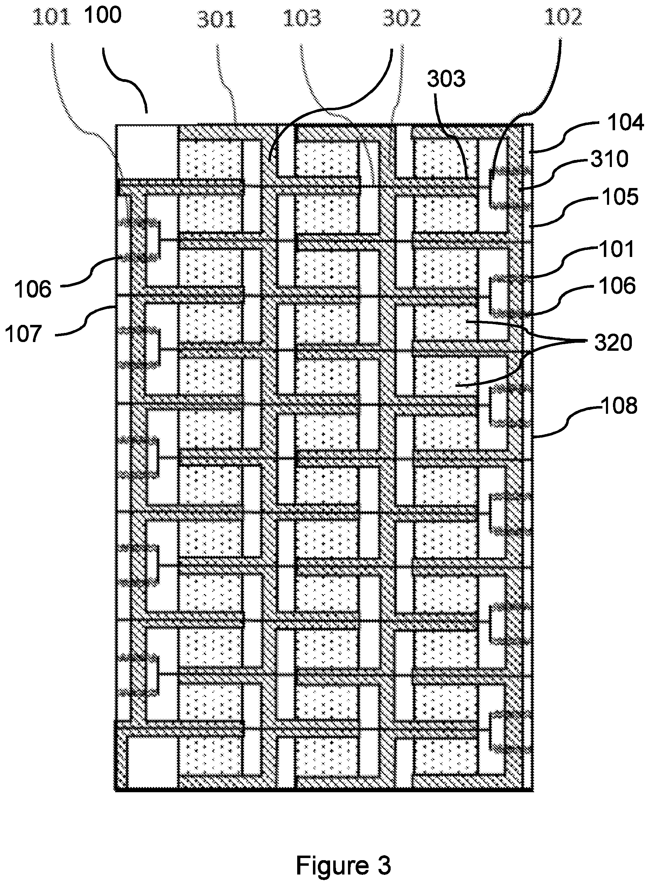

Figure 3 shows an example embodiment of a thermoelectric module comprising a substrate a substrate with a plurality of strips and linking bridges (link portions) with thermoelectric elements disposed thereon. The same reference numerals as in Figures 1 and 2 have been used to indicate corresponding features in Figure 3. In the example embodiment of Figure 3, the substrate 100 has been formed (cut along cut lines 103, 102 and foldable along fold lines 101, 106) into a sequence of 12 strips 104, 105 with link regions 110 therebetween.

A plurality of thermoelectric elements 320, 302 are disposed in electrical series on the strips 104, 105 and link portions 110. The thermoelectric elements 320, 302 comprise, or consist essentially of, thermoelectric materials of different types, for example p and n-type or n and p-type thermoelectric materials respectively. They are electrically connected by electrical interconnects 301 and 303 which, in some embodiments, may be formed of the same thermoelectric material as the thermoelectric elements 302.

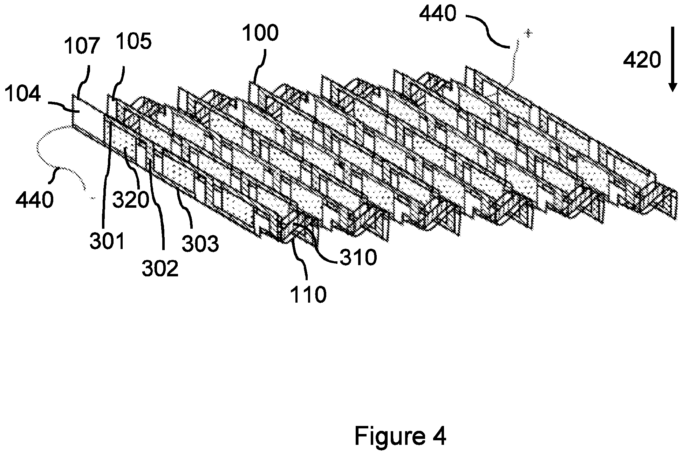

This substrate 100 with its cut lines 102,103 and fold lines 101,106 is formed into a device as shown in Figure 4. Like features in Figure 4 are indicated using the same reference numerals as in Figure 3. All the strips 104, 105 are thermally in parallel, with a direction of heat flow indicated by an arrow 420 predominantly parallel to the strips 104, 105, while electrically the strips 104, 105 are connected in series though the link portions 110. The thermoelectric elements 320, 302 on each strip 104, 105 are insulated from thermoelectric elements 320, 302 on neighbouring strips by the insulating substrate 100. This device architecture is highly scalable and manufacturable as the linking bridges (link portions) size is not dependent on the number of strips 104, 105. Wires 440 may be attached to each end of the device to extract the electrical power generated when a temperature difference is applied across the device, e.g. generally in the direction indicated by the arrow 420. The module/device architecture shown in Figure 4 is configured to fit within a cuboid-shaped envelope. In embodiments, the thermoelectric module or device may be configured to fit within an envelope having a different shape. In the configuration shown in Figure 4, the strips 104, 105 are regularly and uniformly spaced from one another. In embodiments, the strips 104, 105 may be irregularly and/or non-uniformly spaced from one another.

When not cut and folded (e.g. as shown in Figure 3), the thermoelectric elements and electrical interconnects may be disposed on a common surface of the substrate. In embodiments, the theremoelectric elements and electrical interconnects may be disposed on only one surface of the substrate. This may facilitate manufacture. Furthermore, when folded (e.g. as shown in Figure 4), it may mean that the substrate insulates the thermoelectric elements and electrical interconnects in sequentially neighbouring strips from each other.

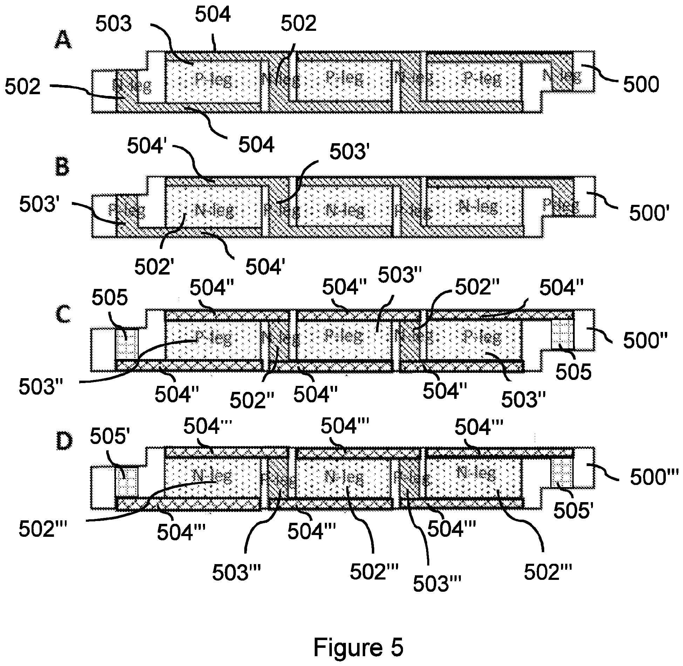

Figure 5 shows four examples labelled A, B, C and D of different strip designs.

Example A shows a substrate strip 500 with a series of n-type 502 and p-type 503 thermoelectric elements or legs disposed thereon, electrically connected by n-type electrical interconnects 504. The n-type thermoelectric elements 502 may have a lower width on the substrate strip 500 perpendicular to an intended predominant heat flow direction than the p-type thermoelectric elements 503. The difference in size of the n-type 502 and p-type 503 thermoelectric elements allows optimised power outputs for the combination of n- and p-type materials that do not have similar thermal and electrical conductivities, or are deposited with different thicknesses.

Example B shows a substrate strip 500' with a series of p-type 503' and n-type 502' thermoelectric elements disposed thereon, electrically connected by p-type electrical interconnects 504'. The p-type thermoelectric elements 503' may have a lower width on the substrate strip 500' perpendicular to an intended predominant heat flow direction than the n-type thermoelectric elements 502'. The difference in size of the n-type 502' and p-type 503' thermoelectric elements allows optimised power outputs for the combination of n- and p-type materials that do not have similar thermal and electrical conductivities, or are deposited with different thicknesses.

Example C shows a substrate strip 500" with p-type 503" and n-type 502" thermoelectric elements disposed thereon, electrically connected by electrical interconnects 504". The electrical interconnects 504" may be made of a different material from the thermoelectric elements 502", 503". The electrical interconnects 504" may be made of a material with a lower electrical resistivity than the thermoelectric elements 502", 503", to reduce resistive losses. The n-type thermoelectric elements 502" may have a lower width on the substrate strip 500" perpendicular to an intended predominant heat flow direction than the p-type thermoelectric elements 503". At each end of the substrate strip 500" there is disposed thereon a link electrical interconnect 505. The link electrical interconnects 505 extend on to a link portion of the substrate. The link electrical interconnects 505 may be made of the same material as the electrical interconnects 504". The link electrical interconnects 505 may be made of a different material from and/or may have a different thickness from the electrical interconnects 504", for example to make the link electrical interconnects 505 more tolerant to bending or folding.

Example D shows a substrate strip 500‴ with p-type 503‴ and n-type 502‴ thermoelectric elements disposed thereon, electrically connected by electrical interconnects 504‴. The electrical interconnects 504‴ may be made of a different material from the thermoelectric elements 502‴, 503‴. The electrical interconnects 504‴ may be made of a material with a lower electrical resistivity than the thermoelectric elements 502‴, 503‴, to reduce resistive losses. The p-type thermoelectric elements 503‴ may have a lower width on the substrate strip 500‴ perpendicular to an intended predominant heat flow direction than the n-type thermoelectric elements 502‴. At each end of the substrate strip 500‴ there is disposed thereon a link electrical interconnect 505'. The link electrical interconnects 505' extend on to a link portion of the substrate. The link electrical interconnects 505' may be made of the same material as the electrical interconnects 504‴. The link electrical interconnects 505' may be made of a different material from and/or may have a different thickness from the electrical interconnects 504‴, for example to make the link electrical interconnects 505' more tolerant to bending or folding.

Each strip will have at least one n-type thermoelectric element and one p-type thermoelectric element disposed on it. Each strip may have any number of n-type thermoelectric elements and p-type thermoelectric elements disposed on the substrate. For instance, each strip may have at least one and/or up to or at least 1000 n-type thermoelectric elements and p-type thermoelectric elements disposed on the substrate.

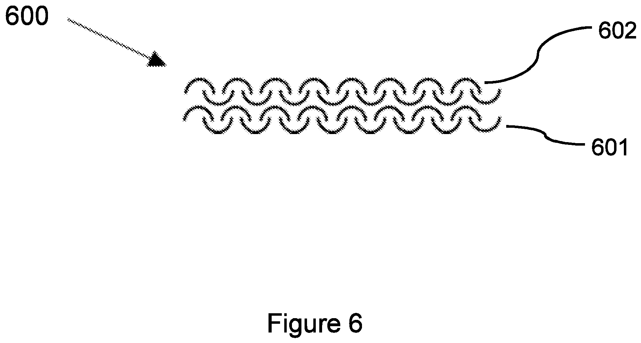

In embodiments, the fold lines (e.g. 101, 106) may be made easier to produce by scoring or cutting the substrate so that the substrate preferentially folds along that line. Figure 6 shows an example of a cutting pattern 600 that may significantly increase the ability of the substrate to fold along a fold line. The cutting pattern 600 comprises a number of cuts in the substrate which increase the flexibility, while not forming a continuous cut line along the fold line, so that physical attachment and electrical continuity is maintained across the fold line. The cuts may comprise or consist of interlocking semicircles 601, 602. There may be one or more, e.g. multiple, rows of these cut features to form a fold line or fold region. This may allow control over the fold position and the radius of curvature of the fold, minimising the potential for damage to the device during the folding operation. The pattern of Figure 6 may be formed by only partial removal of the substrate, i.e. by scoring or partial depth cuts rather than through-thickness cuts. Other cutting patterns may be employed.

The second cut line 102 may have a total length approximately equal to half the total width of the first and second strips (e.g. approximately a quarter of the width of the first strip and a quarter of the width of the second strip). This allows tight packing of the strips. The second cut line 102 may be longer than half the total width of the first and second strips, to ease manufacturing tolerances, or allow additional spacing between the strips. The second cut line 102 may be less than half the total width of the first and second strips.

The n- and p-type thermoelectric elements may comprise, or consist essentially of, one or more theremoelectric materials.

Suitable thermoelectric materials may include bismuth telluride and/or bismuth antimony telluride materials. These materials may provide an advantage in performance, but may suffer from a high cost and brittle nature.

The n- and p-type thermoelectric materials may be formed from organic materials. These materials may provide an advantage in flexibility and may offer the potential for lower cost. For example the p-type thermoelectric material may be PEDOT:PSS.

The n- and p-type thermoelectric materials may be formed from metals. These materials may provide an advantage in flexibility, but may suffer from lower thermoelectric performance. For example the n-type thermoelectric material may be nickel.

The electrical interconnect(s) may include metals, such as copper, silver, nickel, gold. The electrical interconnect may include a number of layers, such as copper, nickel and then gold. The electrical interconnect(s) may be applied by electrolytic or electroless plating. The electrical interconnect(s) may be applied by a printing process, and an optional heat treatment.

The substrate is electrically insulating with a low thermal conductivity. The substrate may comprise, or consist essentially of, polyimide, polyethylene terephalate (PET) or other plastic. The substrate may be foldable. The substrate may not be easily foldable unless enhanced by cuts, partial-depth cuts or scoring in the region of the fold lines.

The thermoelectric elements and electrical interconnects may be formed by a number of thick and thin film methods. For example they may be formed by thermal or electron-beam evaporation, sputtering, electroplating or spray coating, with the patterning produced by masking, photolithographic lift off or etching processes. The thermoelectric elements and electrical interconnects may be formed by stencil printing, ink jet printing or screen printing. The thermoelectric elements may require additional treatments after deposition, for example chemical or thermal treatments.

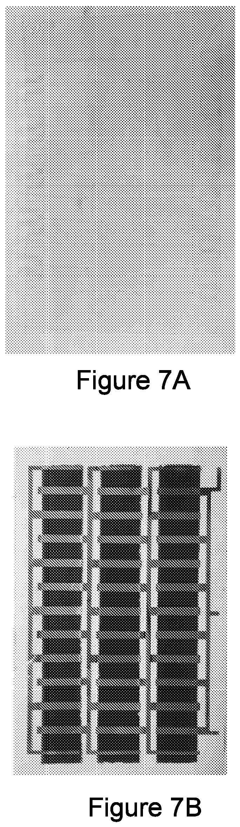

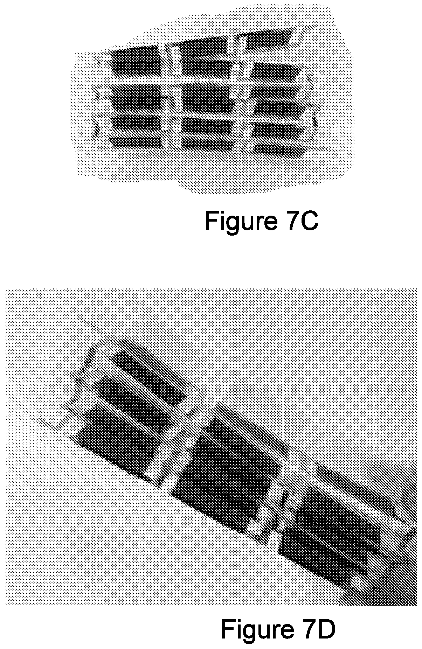

Figures 7A, 7B, 7C and 7D illustrate an an example of the fabrication of a thermoelectric device of one embodiment A polyethylene terephalate (PET substrate), 125µm thick, was cleaned by soap and deionised water, and was cut and etched by a laser cutter with specific patterns as shown in Figure 7A. Spray coating of 1 wt% PEDOT:PSS mixed with 5 wt % dimethyl sulfoxide (DMSO) solution on the pre-cut PET substrate was performed, with the substrate covered by a mask to provide the correct pattern. The PEDOT:PSS was then treated with ethylene glycol (EG) solution for 10 minutes. The thickness of the PEDOT:PSS film is 10 µm, and the width is 20 mm. After it dried, nickel was evaporated onto the substrate and PEDOT:PSS, with patterning provided by a separate mask. The substrate after the PEDOT:PSS and nickel deposition is shown in Figure 7B. The thickness of the nickel film deposited is thinner than the PEDOT:PSS, at 1.48 µm, as well as having narrower thermoelectric elements than the PEDOT:PSS, to balance nickel's higher thermal and electrical conductivity. Finally, the thermoelectric generator device has been popped out from the 2D film, using the fold lines as shown in Figure 7C. The final device is flexible to fit different substrates and can be compressed in one direction to make a more compact device, as shown in Figure 7D.

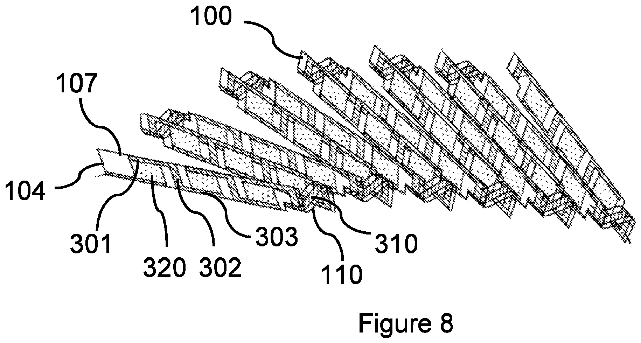

The thermoelectric device may be formed by folding the substrate so that its total volume is approximately a cuboid. The flexibility provided by the linking bridges additionally allows other shapes, such as matching radial shapes or more complex surfaces, as illustrated by Figure 8. Like reference numerals are used in Figure 8 to indicate like features shown in Figures 3 and 4 and described above.

In one embodiment of the invention the electrical interconnects and strips may be elongated in the direction of the heat flow such that the size in the direction of the heat flow of the electrical interconnects is longer than the thermoelectric elements. This may allow the electrical interconnects to act as a heat sink to air, as the thermal conductivity of the electrical interconnects may be high, so the heat transfer to air is enhanced by increasing the surface area over which heat transfer may occur. This may result in a significant weight saving, as the or a heat sink is integrated into the thermoelectric device. The electrical interconnects may act as a heat sink for only the hot side or only the cold side of the device. This approach may be particularly advantageous for the devices where the strips form radii around a curved surface, as the outer edge allows additional space between the elongated electrical interconnects in which air can flow. To allow for more space to improve air flow not all strips may have elongated electrical interconnects, or the electrical interconnects may be elongated in different areas of adjacent or nearby strips.

## Claims

1. A thermoelectric module comprising:
a continuous substrate (100) comprising:
a first region (104) having disposed thereon alternating n-type and p-type thermoelectric elements (320, 302) connected in a first electrical series;
a second region (105) having disposed thereon alternating n-type and p-type thermoelectric elements (320, 302) connected in a second electrical series; and
a link portion (110) extending between the first region and the second region. the link portion having disposed thereon an electrical connection connecting the first electrical series and the second electrical series;
wherein the continuous substrate comprises a first bend or fold (101) between the first region and a first end of the link portion and a second bend or fold (106) between a second end of the link portion and the second region; **characterised in that** the link portion has a width, which is less than 25%, less than 20% or less than 15% of a length of the first portion and/or a length of the second portion.

2. A thermoelectric module according to claim 1, wherein one or more of the following applies:
(i) the direction of the first bend or fold is opposite to the direction of the second bend or fold;
(ii) the continuous substrate is flexible at least in part;
(iii) the continuous substrate is adapted to be foldable or bendable at specific locations.

3. A thermoelectric module according to claim 1 or claim 2, wherein the continuous substrate comprises a line of weakness to facilitate folding or bending at the location of the first bend or fold and/or a line of weakness to facilitate folding or bending at the location of the second bend or fold, optionally wherein the line(s) of weakness comprise a pattern of scoring, partial-depth cuts and/or through-thickness cuts.

4. A thermoelectric module according to any one of claims 1 to 3, wherein the electrical connection connecting the first electrical series and the second electrical series comprises at least one thermoelectric element or wherein the electrical connection connecting the first electrical series and the second electrical series does not include any thermoelectric elements.

5. A thermoelectric module according to any one of claims 1 to 4, wherein at least one electrical interconnect connecting an n-type thermoelectric element to a p-type thermoelectric element in the first electrical series and/or the second electrical series is made of a material having a lower resistivity than the thermoelectric elements in the first electrical series and/or the thermoelectric elements in the second electrical series.

6. A thermoelectric module according to any one of the preceding claims, wherein: the p-type thermoelectric elements have a lower width on the continuous substrate perpendicular to an intended predominant heat flow direction than the n-type thermoelectric elements; or the n-type thermoelectric elements have a lower width on the continuous substrate perpendicular to an intended predominant heat flow direction than the p-type thermoelectric elements.

7. A thermoelectric module according to any one of the preceding claims, wherein: the first region lies in a first plane and the second region lies in a second plane, wherein the second plane is displaced relative to the first plane; and/or wherein the first region comprises an elongate strip extending in a first direction, the second region comprises an elongate strip extending in a second direction and the link portion extends between the first portion and the second portion in a direction at an angle to the first direction and/or the second direction.

8. A thermoelectric module according to any one of the preceding claims, wherein spacing between the regions having disposed thereon alternating n-type and p-type thermoelectric elements connected in an electrical series is regular and/or uniform, or wherein spacing between the regions having disposed thereon alternating n-type and p-type thermoelectric elements connected in an electrical series is irregular and/or non-uniform.

9. A thermoelectric module according to any one of the preceding claims, wherein the continuous substrate comprises more than two regions having disposed thereon alternating n-type and p-type thermoelectric elements connected in an electrical series and a link portion between each sequential pair of regions, to provide an electrical and mechanical connection between the sequential pair of regions, wherein the continuous substrate comprises a first bend or fold at a first end and a second bend or fold at a second end of each link portion, optionally wherein the continuous substrate comprises up to or at least 10, up to or at least 20, up to or at least 40, up to or at least 100 or up to or at least 1000 regions having disposed thereon alternating n-type and p-type thermoelectric elements connected in an electrical series.

10. A thermoelectric module according to any one of the preceding claims, wherein the area of the link portion(s) is less than 25%, less than 20% or less than 15% of the area of the continuous substrate and/or the thermoelectric elements and the electrical connection(s) are disposed on only one surface of the continuous substrate.

11. A thermoelectric device comprising one or more thermoelectric modules according to any one of claims 1 to 10, optionally wherein the thermoelectric device is a thermoelectric generator.

12. Use of a thermoelectric device according to claim 11 to generate electricity.

13. A method of manufacture of a thermoelectric module or a thermoelectric device comprising:
providing a continuous substrate comprising:
a first region having disposed thereon alternating n-type and p-type thermoelectric elements connected in a first electrical series;
a second region having disposed thereon alternating n-type and p-type thermoelectric elements connected in a second electrical series; and
a link portion extending between the first region and the second region, the link portion having disposed thereon an electrical connection connecting the first electrical series and the second electrical series;
bending or folding the continuous substrate to create a first bend or fold between the first region and a first end of the link portion and a second bend or fold between a second end of the link portion and the second region;
**characterised in that**
the link portion has a width, which is less than 25%, less than 20% or less than 15% of a length of the first portion and/or a length of the second portion.

14. A method of manufacture according to claim 13, wherein one or more of the following applies:
(i) the direction of the first bend or fold is opposite to the direction of the second bend or fold; and
(ii) the continuous substrate is adapted to be foldable or bendable at specific locations, optionally wherein the continuous substrate comprises a line of weakness to facilitate folding or bending at the location of the first bend or fold and/or a line of weakness to facilitate folding or bending at the location of the second bend or fold, further optionally wherein the line(s) of weakness comprise a pattern of scoring, partial-depth cuts and/or through-thickness cuts.

15. A method of manufacture according to claim 13 or claim 14 comprising forming the continuous substrate, wherein forming the continuous substrate comprises:
cutting a substrate along a first cut line extending partially across the substrate from a first edge in a direction towards a second edge opposite the first edge of the substrate to partially separate the first region from the second region; and
cutting the substrate along a second cut line, the second cut line meeting the first cut line and extending partially across the substrate at an angle relative to the first cut line without reaching an edge of the substrate.

## Patentansprüche

1. Themoelektrisches Modul, umfassend:
ein kontinuierliches Substrat (100), umfassend:
eine erste Region (104) mit darauf angeordneten abwechselnden thermoelektrischen Elementen vom n-Typ und p-Typ (320, 302), welche in einer ersten elektrischen Serie verbunden sind;
eine zweite Region (105) mit darauf angeordneten abwechselnden thermoelektrischen Elementen vom n-Typ und p-Typ (320, 302), welche in einer zweiten elektrischen Serie verbunden sind; und
einen Verbindungsabschnitt (110), welcher sich zwischen der ersten Region und der zweiten Region erstreckt, wobei auf dem Verbindungsabschnitt eine elektrische Verbindung angeordnet ist, welche die erste elektrische Serie und die zweite elektrische Serie verbindet;
wobei das kontinuierliche Substrat umfassend eine erste Biegung oder einen ersten Falz (101) zwischen der ersten Region und einem ersten Ende des Verbindungsabschnitts und eine zweite Biegung oder einen zweiten Falz (106) zwischen einem zweiten Ende des Verbindungsabschnitts und der zweiten Region umfasst;
**dadurch gekennzeichnet, dass**
der Verbindungsabschnitt eine Breite aufweist, welche weniger als 25 %, weniger als 20 % oder weniger als 15 % einer Länge des ersten Abschnitts und/oder einer Länge des zweiten Abschnitts beträgt.

2. Themoelektrisches Modul nach Anspruch 1, wobei eines oder mehrere der folgenden gilt:
(i) die Richtung der ersten Biegung oder des ersten Falzes ist der Richtung der zweiten Biegung oder des zweiten Falzes entgegengesetzt;
(ii) das kontinuierliche Substrat ist zumindest teilweise flexibel;
(iii) das kontinuierliche Substrat ist adaptiert, um an spezifischen Stellen faltbar oder biegsam zu sein.

3. Thermoelektrisches Modul nach Anspruch 1 oder Anspruch 2, wobei das kontinuierliche Substrat eine Schwächungslinie, um Falten oder Biegen an der Stelle der ersten Biegung oder des ersten Falzes zu erleichtern, und/oder eine Schwächungslinie, um Falten oder Biegen an der Stelle der zweiten Biegung oder des zweiten Falzes zu erleichtern, umfasst, wobei optional die Schwächungslinie(n) ein Ritzmuster, teiltiefe Schnitte und/oder volltiefe Schnitte umfassen.

4. Thermoelektrisches Modul nach einem der Ansprüche 1 bis 3, wobei die elektrische Verbindung, welche die erste elektrische Serie und die zweite elektrische Serie verbindet, zumindest ein thermoelektrisches Element umfasst, oder wobei die elektrische Verbindung, welche die erste elektrische Serie und die zweite elektrische Serie verbindet, keine thermoelektrischen Elemente umfasst.

5. Thermoelektrisches Modul nach einem der Ansprüche 1 bis 4, wobei zumindest eine elektrische Zusammenschaltung, welche ein thermoelektrisches Element vom n-Typ mit einem thermoelektrischen Element vom p-Typ in der ersten elektrischen Serie und/oder der zweiten elektrischen Serie verbindet, aus einem Material hergestellt ist, welches eine niedrigere Resistivität aufweist als die thermoelektrischen Elemente in der ersten elektrischen Serie und/oder die thermoelektrischen Elemente in der zweiten elektrischen Serie.

6. Thermoelektrisches Modul nach einem der vorstehenden Ansprüche, wobei: die thermoelektrischen Elemente vom p-Typ auf dem kontinuierlich Substrat senkrecht zu einer beabsichtigten vorherrschenden Wärmestromrichtung eine niedrigere Breite aufweisen als die thermoelektrischen Elemente vom n-Typ; oder die thermoelektrischen Elemente vom n-Typ auf dem kontinuierlich Substrat senkrecht zu einer beabsichtigten vorherrschenden Wärmestromrichtung eine niedrigere Breite aufweisen als die thermoelektrischen Elemente vom p-Typ.

7. Thermoelektrisches Modul nach einem der vorstehenden Ansprüche, wobei: die erste Region in einer ersten Ebene liegt und die zweite Region in einer zweiten Ebene liegt, wobei die zweite Ebene relativ zu der ersten Ebene verschoben ist; und/oder wobei die erste Region einen länglichen Streifen umfasst, welcher sich in eine erste Richtung erstreckt, die zweite Region einen länglichen Streifen umfasst, welcher sich in eine zweite Richtung erstreckt, und der Verbindungsabschnitt sich zwischen dem ersten Abschnitt und dem zweiten Abschnitt in eine Richtung in einem Winkel zu der ersten Richtung und/oder der zweiten Richtung erstreckt.

8. Thermoelektrisches Modul nach einem der vorstehenden Ansprüche, wobei Abstand zwischen den Regionen mit darauf angeordneten abwechselnden thermoelektrischen Elementen vom n-Typ und p-Typ, welche in einer elektrischen Serie verbunden sind, regelmäßig und/oder einheitlich ist, oder wobei Abstand zwischen den Regionen mit darauf angeordneten abwechselnden thermoelektrischen Elementen vom n-Typ und p-Typ. welche in einer elektrischen Serie verbunden sind, unregelmäßig und/oder nicht einheitlich ist.

9. Thermoelektrisches Modul nach einem der vorstehenden Ansprüche, wobei das kontinuierliche Substrat mehr als zwei Regionen mit darauf angeordneten abwechselnden thermoelektrischen Elementen vom n-Typ und p-Typ, welche in einer elektrischen Serie verbunden sind, und einen Verbindungsabschnitt zwischen jedem fortlaufenden Paar von Region umfasst, um eine elektrische und mechanische Verbindung zwischen dem fortlaufenden Paar von Regionen bereitzustellen, wobei das kontinuierliche Substrat eine erste Biegung oder einen ersten Falz an einem ersten Ende und eine zweite Biegung oder einen zweiten Falz an einem zweiten Ende jedes Verbindungsabschnitts umfasst, wobei optional das kontinuierliche Substrat bis zu oder zumindest 10, bis zu oder zumindest 20, bis zu oder zumindest 40, bis zu oder zumindest 100 oder bis zu oder zumindest 1000 Regionen mit darauf angeordneten abwechselnden thermoelektrischen Elementen vom n-Typ und p-Typ umfasst, welche in einer elektrischen Serie verbunden sind.

10. Thermoelektrisches Modul nach einem der vorstehenden Ansprüche, wobei die Fläche des/der Verbindungsabschnitt(e) weniger als 25 %, weniger als 20 % oder weniger als 15 % der Fläche des kontinuierlichen Substrat beträgt und/oder die thermoelektrischen Elementen und die elektrische(n) Verbindung(en) nur auf einer Oberfläche des kontinuierlichen Substrats angeordnet sind.

11. Thermoelektrische Vorrichtung, welche ein oder mehrere thermoelektrische Module nach einem der Ansprüche 1 bis 10 umfasst, wobei optional die thermoelektrische Vorrichtung ein thermoelektrischer Generator ist.

12. Verwendung einer thermoelektrischen Vorrichtung nach Anspruch 11 zum Erzeugen von Elektrizität.

13. Verfahren zur Herstellung eines thermoelektrischen Moduls oder einer thermoelektrischen Vorrichtung umfassend:
Bereitstellen eines kontinuierlichen Substrats, umfassend:
eine erste Region mit darauf angeordneten abwechselnden thermoelektrischen Elementen vom n-Typ und p-Typ, welche in einer ersten elektrischen Serie verbunden sind; und
eine zweite Region mit darauf angeordneten abwechselnden thermoelektrischen Elementen vom n-Typ und p-Typ, welche in einer zweiten elektrischen Serie verbunden sind; und
einen Verbindungsabschnitt, welcher sich zwischen der ersten Region und der zweiten Region erstreckt, wobei auf dem Verbindungsabschnitt eine elektrische Verbindung angeordnet ist, welche die erste elektrische Serie und die zweite elektrische Serie verbindet;
Biegen oder Falzen des kontinuierlichen Substrats, um eine erste Biegung oder einen ersten Falz zwischen der ersten Region und einem ersten Ende des Verbindungsabschnitts und eine zweite Biegung oder einen zweiten Falz zwischen einem zweiten Ende des Verbindungsabschnitts und der zweiten Region zu erstellen;
**dadurch gekennzeichnet, dass**
der Verbindungsabschnitt eine Breite aufweist, welche weniger als 25 %, weniger als 20 % oder weniger als 15 % einer Länge des ersten Abschnitts und/oder einer Länge des zweiten Abschnitts beträgt.

14. Verfahren zur Herstellung nach Anspruch 13, wobei eines oder mehrere der folgenden gilt:
(i) die Richtung der ersten Biegung oder des ersten Falzes ist der Richtung der zweiten Biegung oder des zweiten Falzes entgegengesetzt; und
(ii) das kontinuierliche Substrat ist adaptiert, um an spezifischen Stellen faltbar oder biegsam zu sein, optional wobei das kontinuierliche Substrat eine Schwächungslinie, um Falten oder Biegen an der Stelle der ersten Biegung oder des ersten Falzes zu erleichtern, und/oder eine Schwächungslinie, um Falten oder Biegen an der Stelle der zweiten Biegung oder des zweiten Falzes zu erleichtern, umfasst, wobei weiter optional die Schwächungslinie(n) ein Ritzmuster, teiltiefe Schnitte und/oder volltiefe Schnitte umfassen.

15. Verfahren zur Herstellung nach Anspruch 13 oder Anspruch 14, umfassend Bilden des kontinuierlichen Substrats, wobei Bilden des kontinuierlichen Substrats umfasst:
Schneiden eines Substrats entlang einer ersten Schnittlinie, welche sich von einem ersten Rand in einer Richtung zu einem zweiten Rand gegenüber dem ersten Rand des Substrats teilweise durch das Substrat erstreckt, um die erste Region teilweise von der zweiten Region zu trennen; und
Schneiden des Substrats entlang einer zweiten Schnittlinie, wobei die zweite Schnittlinie die erste Schnittlinie trifft und sich teilweise in einem Winkel relativ zu der ersten Schnittlinie durch das Substrat erstreckt, ohne einen Rand des Substrats zu erreichen.

## Revendications

1. Module thermoélectrique comprenant :
un substrat continu (100), comprenant :
une première région (104) présentant, disposés sur celle-ci, des éléments thermoélectriques de type n et de type p (320, 302) alternés connectés en une première série électrique ;
une seconde région (105) présentant, disposés sur celle-ci, des éléments thermoélectriques de type n et de type p (320, 302) alternés connectés en une seconde série électrique ; et
une partie de liaison (110) s'étendant entre la première région et la seconde région, la partie de liaison présentant, disposée sur celle-ci, une connexion électrique connectant la première série électrique et la seconde série électrique ;
dans lequel le substrat continu comprend un premier coude ou pli (101) entre la première région et une première extrémité de la partie de liaison et un second coude ou pli (106) entre une seconde extrémité de la partie de liaison et la seconde région ;
**caractérisé en ce que**
la partie de liaison présente une largeur, qui est inférieure à 25 %, inférieure à 20 % ou inférieure à 15 % d'une longueur de la première partie et/ou d'une longueur de la seconde partie.

2. Module thermoélectrique selon la revendication 1, dans lequel une ou plusieurs des conditions suivantes s'applique(nt) :
(i) la direction du premier coude ou pli est opposée à la direction du second coude ou pli ;
(ii) le substrat continu est flexible au moins en partie ;
(iii) le substrat continu est adapté pour pouvoir être plié ou cintré à des emplacements spécifiques.

3. Module thermoélectrique selon la revendication 1 ou la revendication 2, dans lequel le substrat continu comprend une ligne de fragilité pour faciliter le pliage ou le cintrage à l'emplacement du premier coude ou pli et/ou une ligne de fragilité pour faciliter le pliage ou le cintrage à l'emplacement du second coude ou pli, éventuellement dans lequel la/les ligne(s) de fragilité comprend/comprennent un motif de rainage, de coupures de profondeur partielle et/ou de coupures traversant l'épaisseur.

4. Module thermoélectrique selon l'une quelconque des revendications 1 à 3, dans lequel la connexion électrique connectant la première série électrique et la seconde série électrique comprend au moins un élément thermoélectrique ou dans lequel la connexion électrique connectant la première série électrique et la seconde série électrique n'inclut pas de quelconques éléments thermoélectriques.

5. Module thermoélectrique selon l'une quelconque des revendications 1 à 4, dans lequel une interconnexion électrique connectant un élément thermoélectrique de type n à un élément thermoélectrique de type p dans la première série électrique et/ou la seconde série électrique est réalisée en un matériau présentant une résistivité plus faible que les éléments thermoélectriques dans la première série électrique et/ou les éléments thermoélectriques dans la seconde série électrique.

6. Module thermoélectrique selon l'une quelconque des revendications précédentes, dans lequel : les éléments thermoélectriques de type p présentent une largeur plus faible sur le substrat continu perpendiculaire à une direction de flux de chaleur prédominante prévue que les éléments thermoélectriques de type n, ou les éléments thermoélectriques de type n présentent une largeur plus faible sur le substrat continu perpendiculaire à une direction de flux de chaleur prédominante prévue que les éléments thermoélectriques de type p.

7. Module thermoélectrique selon l'une quelconque des revendications précédentes, dans lequel : la première région se trouve dans un premier plan et la seconde région se trouve dans un second plan, dans lequel le second plan est déplacé par rapport au premier plan ; et/ou dans lequel la première région comprend une bande allongée s'étendant dans une première direction, la seconde région comprend une bande allongée s'étendant dans une seconde direction et la partie de liaison s'étend entre la première partie et la seconde partie dans une direction à un angle par rapport à la première direction et/ou la seconde direction.

8. Module thermoélectrique selon l'une quelconque des revendications précédentes, dans lequel l'espacement entre les régions présentant, disposés sur celles-ci, des éléments thermoélectriques de type n et de type p alternés connectés en une série électrique est régulier et/ou uniforme, ou dans lequel l'espacement entre les régions présentant, disposés sur celles-ci, des éléments thermoélectriques de type n et de type p connectés en une série électrique est irrégulier et/ou non uniforme.

9. Module thermoélectrique selon l'une quelconque des revendications précédentes, dans lequel le substrat continu comprend plus de deux régions présentant, disposés sur celles-ci, des éléments thermoélectriques de type n et de type p alternés connectés en une série électrique et une partie de liaison entre chaque paire séquentielle de régions, pour fournir une connexion électrique et mécanique entre la paire séquentielle de régions, dans lequel le substrat continu comprend un premier coude ou pli à une première extrémité et un second coude ou pli à une seconde extrémité de chaque partie de liaison, éventuellement dans lequel le substrat continu comprend jusqu'à 10 régions au moins, jusqu'à 20 régions au moins, jusqu'à 40 régions au moins, jusqu'à 100 au moins ou jusqu'à 1000 régions au moins présentant, disposés sur celles-ci, des éléments thermoélectriques de type n et de type p alternatifs connectés en une série électrique.

10. Module thermoélectrique selon l'une quelconque des revendications précédentes, dans lequel la surface de la/des partie(s) de liaison est inférieure à 25 %, inférieure à 20 % ou inférieure à 15 % de la surface du substrat continu et/ou les éléments thermoélectriques et la/les connexion(s) électrique(s) sont disposés sur une seule surface du substrat continu.

11. Dispositif thermoélectrique comprenant un ou plusieurs modules thermoélectriques selon l'une quelconque des revendications 1 à 10, éventuellement dans lequel le dispositif thermoélectrique est un générateur thermoélectrique.

12. Utilisation d'un dispositif thermoélectrique selon la revendication 11 pour générer de l'électricité.

13. Procédé de fabrication d'un module thermoélectrique ou d'un dispositif thermoélectrique comprenant :
la fourniture d'un substrat continu comprenant :
une première région présentant, disposés sur celle-ci, des éléments thermoélectriques de type n et de type p alternés connectés en une première série électrique ;
une seconde région présentant, disposés sur celle-ci, des éléments thermoélectriques de type n et de type p alternés connectés en une seconde série électrique ; et
une partie de liaison s'étendant entre la première région et la seconde région, la partie de liaison présentant, disposée sur celle-ci, une connexion électrique connectant la première série électrique et la seconde série électrique ;
le cintrage ou pliage du substrat continu pour créer un premier coude ou pli entre la première région et une première extrémité de la partie de liaison et un second coude ou pli entre une seconde extrémité de la partie de liaison et la seconde région ;
**caractérisé en ce que**
la partie de liaison présente une largeur, qui est inférieure à 25 %, inférieure à 20 % ou inférieure à 15 % d'une longueur de la première partie et/ou d'une longueur de la seconde partie.

14. Procédé de fabrication selon la revendication 13, dans lequel une ou plusieurs des conditions suivantes s'applique(nt) :
(i) la direction du premier coude ou pli est opposée à la direction du second coude ou pli ; et
(ii) le substrat continu est adapté pour pouvoir être plié ou cintré à des emplacements spécifiques, éventuellement dans lequel le substrat continu comprend une ligne de fragilité pour faciliter le pliage ou le cintrage à l'emplacement du premier coude ou pli et/ou une ligne de fragilité pour faciliter le pliage ou le cintrage à l'emplacement du second coude ou pli, en outre éventuellement dans lequel la/les ligne(s) de fragilité comprend/comprennent un motif de rainage, de coupures de profondeur partielle et/ou de coupures traversant l'épaisseur.

15. Procédé de fabrication selon la revendication 13 ou la revendication 14, comprenant la formation du substrat continu, dans lequel la formation du substrat continu comprend :
la découpe d'un substrat le long d'une première ligne de découpe s'étendant partiellement à travers le substrat depuis un premier bord dans une direction vers un second bord opposé au premier bord du substrat pour séparer partiellement la première région de la seconde région ; et
la découpe du substrat le long d'une seconde ligne de découpe, la seconde ligne de découpe rencontrant la première ligne de découpe et s'étendant partiellement à travers le substrat à un angle par rapport à la première ligne de découpe sans atteindre un bord du substrat.
